# EUROPEAN PATENT APPLICATION

(11) **EP 2 251 916 A1**
(43) Date of publication of application: **17.11.2010**
(21) Application number: 10162697.6
(22) Date of filing: 12.05.2010
(51) Int. Cl.: H01L 33/14, H01L 33/02

(54) **Light emitting device, light emitting device package and lighting system including the same**

(30) Priority: 14.05.2009 KR 20090041971
(71) Applicant: LG Innotek Co., Ltd., Seoul 100-714 (KR)
(72) Inventor: Hwang, Sung Min, Gyeonggi-do (KR); Park, Gyeong Geun, Gyeonggi-do (KR)
(74) Representative: Cabinet Plasseraud

(57) **Abstract**

Provided are a light emitting device (LED), a light emitting device package and a lighting system including the same. The LED includes a light emitting structure having a second semiconductor layer of a second conductivity type, an active layer on the second semiconductor layer, and a first semiconductor layer of a first conductivity type on the active layer, a current blocking layer below the second semiconductor layer, a second electrode below the second semiconductor layer, and a first electrode on the first semiconductor layer. The current blocking layer includes a non second conductive region.

## Description

### BACKGROUND

### 1. Field

A light emitting device, package, and system are disclosed herein.

### 2. Background

A light emitting device, a light emitting device package, and a lighting system including the same are known. However, they suffer from various disadvantages.

### BRIEF DESCRIPTION OF THE DRAWINGS

The embodiments will be described in detail with reference to the following drawings in which like reference numerals refer to like elements, wherein:

Figure 1 is a sectional view of a light emitting device (LED) according to an embodiment.

Figures 2 to 4 are sectional views illustrating a process of manufacturing the LED according to an embodiment.

Figure 5 is a sectional view of an LED according to another embodiment.

Figures 6 to 8 are sectional views illustrating a process of manufacturing the LED according to another embodiment.

Figure 9 is a sectional view of an LED package according to an embodiment.

### DETAILED DESCRIPTION

Light emitting devices (LEDs) are semiconductor devices that convert a current into light. Red and green LEDs may be used as light sources for electronic devices, including information communication devices. For example, a gallium nitride (GaN) semiconductor has a high thermal stability and a wide band gap. The GaN semiconductor may be combined with other elements (e.g., In and Al) to fabricate a semiconductor layer emitting green, blue or white light, and its emitted wavelength may be controlled. Thus, LEDs including the GaN semiconductor may be used in high-power electronic devices.

The LEDs may be a lateral type or a vertical type. In vertical LEDs, an n-type electrode and a p-type electrode that inject current are disposed at an upper side and a lower side of the LEDs, respectively. Electrons and holes injected by the n-type electrode and the p-type electrode, respectively, flow into an active layer where they combine with each other to generate light that may be emitted.

A portion of the light generated in the active layer may be reflected by the n-type electrode. Thus, the reflected light may be lost within the LED, thus light emission efficiency may be reduced. Further, heat may be generated by re-absorbing the light reflected by the n-type electrode. A phenomenon of electron overflow may also occur below the n-type electrode which reduces the amount of emitted light. The electrons and holes may combine in a region outside the active layer which may generate additional heat. Current crowding may additionally deteriorate lifetime and reliability of the LED.

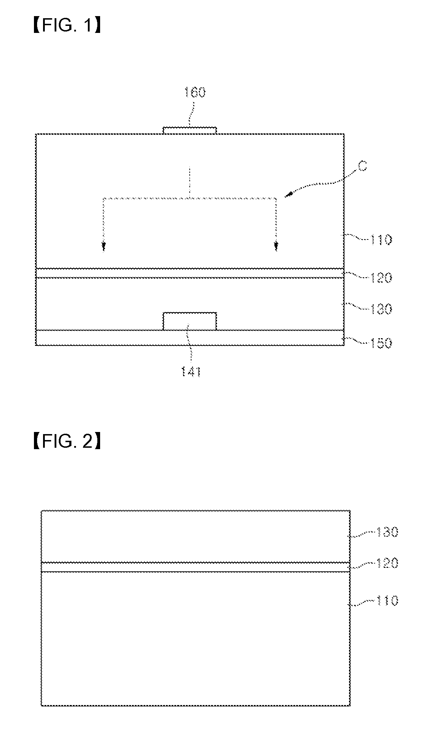

Figure 1 is a sectional view of a light emitting device (LED) according to an embodiment. A light emitting device (LED) according to this embodiment may include a light emitting structure, a first current blocking layer 141, a second electrode 150, and a first electrode 160. The light emitting structure may include a second semiconductor layer 130 of a second conductivity type, an active layer 120, and a first semiconductor layer 110 of a first conductivity type. The first current blocking layer 141 may be disposed on the second semiconductor layer 130. The second electrode 150 may be disposed on the second semiconductor layer 130 and the first current blocking layer 141. The first electrode 160 may be disposed on the first semiconductor layer 110.

The first current blocking layer 141 may be disposed in the second semiconductor layer 130, but is not limited thereto. The current blocking layer 141 may be disposed to induce a voltage drop that may adjust carrier distribution in the active layer 120. For example, a doping concentration and thickness of a first conductive region that forms the current blocking layer 141 may be adjusted, or an ohmic contact with the second electrode may be adjusted to adjust the voltage drop in the active region defined below the first electrode, thereby reducing the electron overflow as well as improving current spreading and light emitting power.

A method of manufacturing the LED according to an embodiment will be described with reference to Figures 2 to 4. A first substrate is prepared. The first substrate may be a sapphire substrate, a SiC substrate, or other appropriate material based on the intended use of the material. A wet etching process may be performed on the first substrate to remove impurities on a surface of the first substrate.

A first semiconductor layer 110 of a first conductivity type may be formed on the first substrate. For example, an n-type GaN layer of the first semiconductor layer 110 of the first conductivity type may be formed using a chemical vapor deposition (CVD) process, a molecular beam epitaxy (MBE) process, a sputtering process, a hydride vapor phase epitaxial (HVPE) deposition process, or other appropriate processes. Also, trimethylgallium gas (TMGa), ammonia gas (NH₃), nitrogen gas (N₂), silane gas (SiH₄), or other appropriate gases containing n-type impurities, such as silicon (Si), may be injected into a chamber to form the first semiconductor layer 110.

An undoped semiconductor layer may be formed on the first substrate, and the first semiconductor layer 110 of the first conductivity type may be formed on the undoped semiconductor layer. For example, an undoped GaN layer may be formed on the first substrate, then an n-type GaN layer may be formed on the undoped GaN layer to form the first semiconductor layer 110 of the first conductivity type.

An active layer 120 may be formed on the first semiconductor layer 110. In the active layer 120, electrons injected through the first semiconductor layer 110 of the first conductivity type may combine when holes injected through the second semiconductor layer 130 of the second conductivity type to emit light having energy that is determined by an energy band of a material constituting the active layer (e.g., the light emitting layer).

The active layer 120 may include at least one of a single quantum well structure, a multi-quantum well (MQW) structure, a quantum wire structure, and a quantum dot structure or other appropriate structures. For example, the active layer 120 may have the multi-quantum well (MQW) structure of an InGaN/GaN structure formed by implanting a trimethyl gallium gas (TMGa), an ammonium gas (NH₃), a nitrogen gas (N₂), a Trimethyl indium gas (TMIn), or other appropriate gases. The active layer 120 may have one or more structures of an InGaN/GaN structure, an InGaN/InGaN structure, an AIGaN/GaN structure, an InAlGaN/GaN structure, a GaAs/AlGaAs(InGaAs) structure, a GaP/AlGaP(InGaP) structure, or other appropriate structures.

A second semiconductor layer 130 of the second conductivity type may be formed on the active layer 120. For example, bis(ethylcyclopentadienyl) magnesium (EtCp₂Mg){Mg(C₂H₅C₅H₄)₂} containing p-type impurities, such as trimethyl gallium (TMGa) gas, ammonia (NH₃) gas, nitrogen (N₂) gas, magnesium (Mg), or other appropriate gases may be injected into the chamber to form a p-type GaN layer of the second semiconductor layer 130 of the second conductivity type, but is not limited thereto.

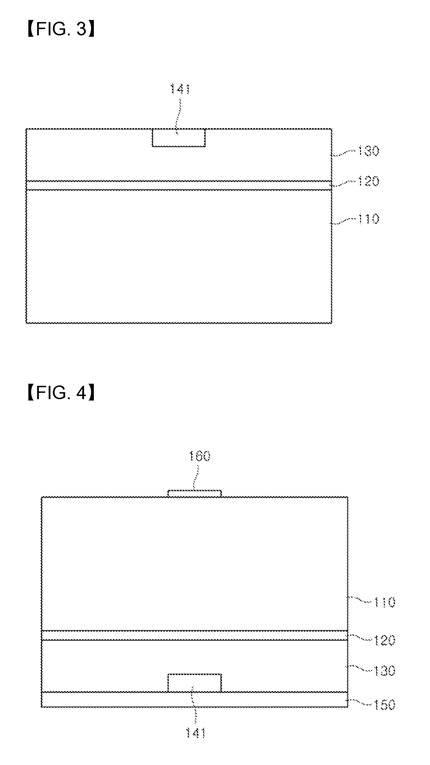

Referring to Figure 3, a first current blocking layer 141 may be formed on the second semiconductor layer 130 of the second conductivity type. The first current blocking layer 141 may include a semiconductor region of a conductivity type different than the second conductivity type. For example, the first current blocking layer 141 may be a first conductive region or a non-conductive region that may be formed by performing a diffusion or ion implantation process on the second semiconductor layer 130 of the second conductivity type. A first pattern exposing a region in which the first current blocking layer 141 may be formed on the second semiconductor layer 130. The diffusion or ion implantation process may be performed using the first pattern as a mask. The first current blocking layer 141 may be formed at a position which spatially corresponds to a first electrode 160 that will be formed later. For example, current blocking layer 141 may be formed to spatially overlap the first electrode 160. The spatial overlap may be a complete overlap or partial overlap.

The current blocking layer 141 may be formed to cause a voltage drop when a constant voltage is applied. Thus, an energy barrier of the active layer 120 may increase in a region below the current blocking layer 141 to reduce carrier flow, thereby preventing electrons and holes from being combined with each other. Referring now to Figure 4, an ohmic contact is provided between the second electrode 150 and the second semiconductor layer 130 other than where the current blocking layer 141 contacts the second semiconductor layer 130, thereby allowing carriers to smoothly flow through the ohmic contact. Such a structure may increase current spreading efficiency that may improve light extraction efficiency.

For example, the current blocking layer 141 may be formed to induce the voltage drop which adjusts carrier distribution in the active layer. In particular, a doping concentration and thickness of the first conductive region that forms the current blocking layer 141 may be adjusted, or an ohmic contact between the second electrode may be adjusted to adjust the voltage drop in the active region defined below the first electrode, thereby reducing the electron overflow as well as improving the current spreading and a light emitting power.

As shown in Figure 4, the first pattern may be removed, and a second electrode 150 may be formed on the second semiconductor layer 130. The second electrode 150 may include an ohmic layer, a reflective layer, a coupling layer (e.g., junction layer), and a second substrate. The second electrode 150 may be formed of at least one of Titanium (Ti), Chrome (Cr), Nickel (Ni), Platinum (Pe), Gold (Av), Tungsten (N), or other appropriate materials, and a semiconductor substrate in which impurities are injected.

The second electrode 150 may include the ohmic layer that may be formed by stacking a material, such as, a single metal, a metal alloy, a metal oxide, or other appropriate materials, in multiple layers to improve the efficiency of electron hole injection. The ohmic layer may be formed of at least one of ITO, IZO(In-ZnO), GZO(Ga-ZnO), AZO(Al-ZnO), AGZO(Al-Ga ZnO), IGZO(In-Ga ZnO), IrOx, RuOx, RuOx/ITO, Ni/IrOx/Au, Ni/IrOx/Au/ITO, Ni, Pt, Cr, Ti, Ag, or other appropriate materials.

When the second electrode 150 includes the reflective layer, the second electrode 150 may include a metal layer containing Al, Ag, an alloy containing Al or Ag, or other appropriate materials. The material, such as Al or Ag, may effectively reflect light generated at the active layer to improve light extraction efficiency, or optical efficiency, of the LED. When the second electrode 150 further includes the coupling layer, the reflective layer may serve as the coupling layer, or the coupling layer may be formed using Ni or Au, or other appropriate materials.

The second electrode 150 may further include the second substrate. However, when the first semiconductor layer 110 of the first conductivity type has a sufficient thickness of about 50 µm or greater, the second electrode 150 may, alternatively, not include the second substrate. The second substrate may be formed of a metal having good conductive properties, a metal alloy, a conductive semiconductor material, or other appropriate conductive material, to efficiently inject holes into the light emitting structure. For example, the second substrate may be formed of one or more of copper (Cu), a Cu alloy, Si, molybdenum (Mo), SiGe, or other appropriate materials. The second substrate may be formed using an electrochemical metal deposition method, a bonding method using eutectic metals, or other appropriate methods.

The first substrate may be removed to expose the first semiconductor layer 110 or the undoped semiconductor layer. The first substrate may be separated using a high power laser or removed using a chemical etching process. The first substrate may be also removed by performing a physical grinding process. Thereafter, the first electrode 160 may be formed on the first semiconductor layer 110. The first electrode 160 may be formed to spatially correspond to, the first current blocking layer 141. For example, the first electrode 160 may be formed on first semiconductor layer 110 to overlap a region occupied by the first current blocking layer 141 on the second semiconductor layer 150.

Since the first current blocking layer 141 may be placed in a region of the second semiconductor layer that spatially corresponds to, or at least partially overlaps, the first electrode 160, current C may not easily flow into the region above the first current blocking layer 141 may be reduced. Thus, current C may be diffused into a region outside the region above the first current blocking layer 141. For example, the first current blocking layer 141 may include the first conductive region to serve as a current blocking layer 141. Thus, efficient current flow may be realized to improve reliability, and light absorption may be minimized to increase the amount of light that may be produced.

Further, the light extraction efficiency may be increased by including a light extraction structure. For example, this embodiment may increase the light extraction efficiency by forming a photonic crystal or a roughness on the first semiconductor layer 110 of the first conductivity type, but is not limited thereto. The current blocking layer 141 may also be formed to efficiently adjust the current flow, thereby increasing the light extraction efficiency. The current blocking layer 141 may also improve the reliability due to the current spreading effect, and thereby increase a light output power.

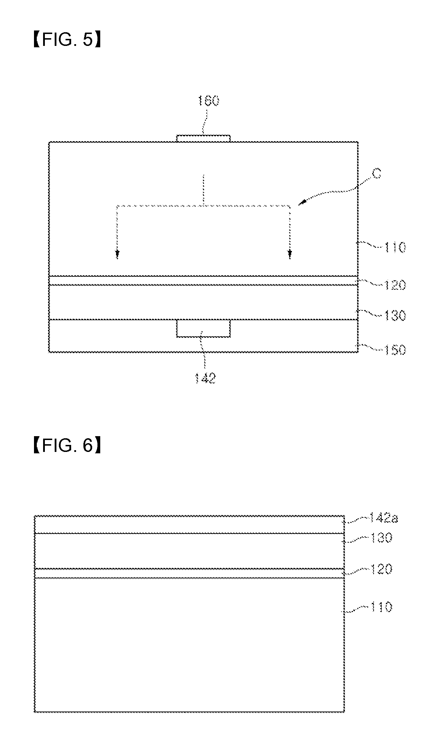

Figure 5 is a sectional view of an LED according to another embodiment. An LED according to this embodiment may include a light emitting structure, a second current blocking layer 142, a second electrode 150, and a first electrode 160. The light emitting structure may include a second semiconductor layer 130 of a second conductivity type, an active layer 120, and a first semiconductor layer 110 of a first conductivity type. The second current blocking layer 142 may be disposed on the second semiconductor layer 130. The second electrode 150 may be disposed on the second semiconductor layer 130. The first electrode 160 may be disposed on the first semiconductor layer 110. In this embodiment, the second current blocking layer 142 may be disposed in the second electrode 150, but is not limited thereto.

This embodiment may adopt the technical features of the embodiments discussed previously. Thus, where possible, the disclosure of this embodiment will be directed to the differences to the previous embodiments. In this embodiment, the second current blocking layer 142 may be disposed on the second semiconductor layer 130, or alternatively, in the second electrode 150.

A method of manufacturing the LED according to the second embodiment will be described with reference to Figures 6 to 8. Referring to Figure 6, a first substrate (not shown) is prepared. Thereafter, a first semiconductor layer 110 of a first conductivity type, an active layer 120, and a second semiconductor layer 130 of a second conductivity type are formed on the first substrate. A second current blocking layer 142 may be formed on the second semiconductor layer 130. In this embodiment, the second current blocking layer 142 may include a semiconductor region of a conductivity type different than the second conductivity type.

In this embodiment, the second current blocking layer 142 including a semiconductor region, e.g., a first conductive layer doped with n-type impurities or a non-conductive layer, may be formed on the second semiconductor layer 130 of the second conductivity type. For example, the first conductive layer or the non-conductive layer may be epitaxially grown, but is not limited thereto.

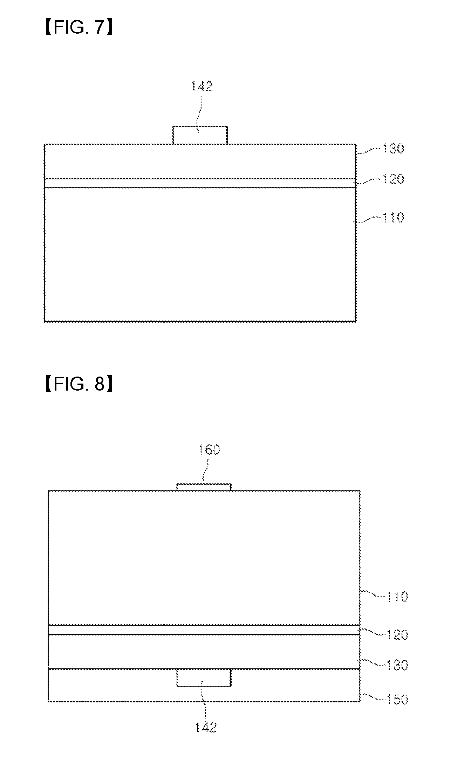

Referring to Figure 7, a first pattern exposing a region in which the second current blocking layer 142 will be formed may be formed. Then, the first conductive layer 142a may be etched using the second pattern as an etch mask to form the second current blocking layer 142. The second current blocking layer 142 may be formed at a position that spatially corresponds to a first electrode 160 that will be formed later.

The current blocking layer 142 may be formed to cause a voltage drop when a constant voltage is applied. Thus, an energy barrier of the active layer 120 may increase in a region below the current blocking layer 142, thereby decreasing carrier flow and preventing electron and hole combination at that region. Further, a second electrode 150 (discussed in further detail below) has an ohmic contact with the second semiconductor layer 130 on surfaces other than where the current blocking layer 142 is positioned to allow carriers to smoothly flow through the ohmic contact. Such a structure may increase current spreading efficiency that may improve light extraction efficiency.

For example, the current blocking layer 142 may be formed to induce the voltage drop which adjusts carrier distribution in the active layer. In particular, a doping concentration and thickness of the first conductive region that forms the current blocking layer 142 may be adjusted, or an ohmic contact between the second electrode may be adjusted to adjust the voltage drop in the active region defined below the first electrode, thereby reducing the electron overflow as well as improving the current spreading and a light emitting power.

As shown in Figure 8, the second pattern may be removed, and the second electrode 150 may be formed on the second semiconductor layer 130. The second electrode 150 may include an ohmic layer, a reflective layer, a coupling layer (e.g., junction layer), and a second substrate. The first substrate may be removed to expose the first semiconductor layer 110. The first electrode 160 may then be formed on the first semiconductor layer 110. The first electrode 160 may be positioned to spatially overlap the second current blocking layer 142.

Since the second current blocking layer 142 may be formed on a region of the second semiconductor layer 130 that spatially corresponds below the first electrode 160, current C may not easily flow into the region above the second current blocking layer 142. Thus, current C may be diffused into a region outside the region above the second current blocking layer 142. Moreover, efficient current flow may be realized to improve reliability, and light absorption may be minimized increase the amount of light that may be produced. The current blocking layer 142 may also be formed to vary the efficiency of current flow, thereby increasing the light extraction efficiency. The current blocking layer may also improve the reliability due to the current spreading effect, and thereby increase a light output power.

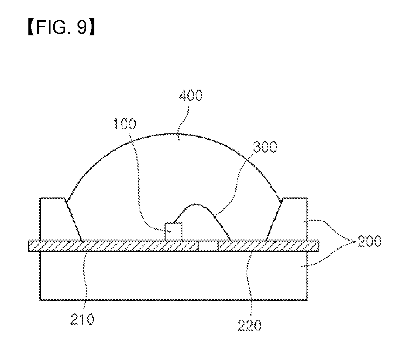

Figure 9 is a sectional view of an LED package according to an embodiment. Referring to Figure 9, an LED package according to an embodiment includes a body 200, a third electrode layer 210 and a fourth electrode layer 220 disposed in the body 200, an LED 100 disposed in the body 200 and electrically connected to the third electrode layer 210 and the fourth electrode layer 220, and a molding member 400 surrounding the LED 100.

The body 200 may be formed of a silicon material, a synthetic resin material, a metal material, or other appropriate materials. A sloped surface may be disposed around the LED 100.

The third electrode layer 210 and the fourth electrode layer 220 are electrically separated from each other, and may supply power to the LED 100. Also, the third electrode layer 210 and the fourth electrode layer 220 may reflect light generated in the LED 100 to improve light efficiency. In addition, the third electrode layer 210 and the fourth electrode layer 220 may transfer heat generated in the LED 100 to the body 200.

LED 100 may be a vertical type LED as illustrated in Figure 1, but is not limited thereto. For example, a lateral type LED may be applicable as the LED 100. The LED 100 may be disposed on the body 200 or on the third electrode layer 210 or the fourth electrode layer 220.

The LED 100 may be electrically connected to the third electrode layer 210 and/or the fourth electrode layer 220 through a wire 300. In this embodiment, if a vertical type LED 100 is used, for example, one wire 300 may be used, but is not limited thereto. Further, when the LED 100 includes the lateral type LED, two wires may be used. Also, when the LED 100 includes a flip-chip type LED, the wire 300 may not be needed. Further, the molding member 400 may surround the LED 100 to protect the LED 100. A phosphor may be also contained in the molding member 400 to vary a wavelength of light emitted from the LED 100.

The current blocking layer may be formed to efficiently adjust the current flow, thereby increasing the light extraction efficiency. The current blocking layer 142 may be also formed to improve the reliability due to the current spreading effect and increase the light output power.

In the LED package according to an embodiment, a plurality of LED packages are arranged in an array on a substrate. A light guide panel, a prism sheet, and a diffusion sheet, which are optical members, may be disposed on an optical path of the LED package. The LED package, the substrate, and the optical member may serve as a light unit. In another embodiment, a display device, an indication device, and a light system, which may include the LED or the LED package disclosed in the above-described embodiments, may be realized. For example, the lighting system, including a light emitting module including the LED package may be used as a lamp or streetlight.

Embodiments provide a light emitting device that can improve current crowding and light extraction efficiency, a light emitting device package and a lighting system including the same.

In one embodiment, a light emitting device (LED) comprises: a light emitting structure comprising a second conductive type semiconductor layer, an active layer on the second conductive type semiconductor layer, and a first conductive type semiconductor layer on the active layer; a current blocking layer below the second conductive type semiconductor layer; a second electrode below the second conductive type semiconductor layer; and a first electrode on the first conductive type semiconductor layer, wherein the current blocking layer comprises a non second conductive region.

In another embodiment, an LED package comprises the LED; and a package body in which the LED is disposed.

In further another embodiment, a lighting system comprises a light emitting module comprising the LED package.

A light emitting device (LED) comprises a light emitting structure comprising a first semiconductor layer of a first conductivity type, an active layer adjacent the first semiconductor layer, and a second semiconductor layer of a second conductivity type adjacent the active layer; a current blocking layer adjacent to the second semiconductor layer; a first electrode adjacent the first semiconductor layer; and a second electrode adjacent the second semiconductor layer; and wherein the current blocking layer comprises a semiconductor region.

The LED includes the current blocking layer comprising a GaN semiconductor layer; wherein the semiconductor region has a first conductivity type; wherein the semiconductor region is an undoped semiconductor region; wherein the semiconductor region is a lightly doped semiconductor region; wherein the first electrode spatially overlaps at least portion of the current blocking layer; wherein the current blocking layer is disposed in the second semiconductor layer; wherein the current blocking layer is disposed in the second electrode; and wherein an ohmic contact is provided between the second semiconductor layer and the second electrode other than where the current blocking layer contacts the second semiconductor layer.

A method of manufacturing a light emitting device (LED) comprises forming an active layer on a first semiconductor layer of a first conductivity type; forming a second semiconductor layer of a second conductivity type on the active layer; forming a current blocking layer including a semiconductor region on the second semiconductor layer; forming a first electrode on the first semiconductor layer, wherein the first electrode is positioned to spatially overlap the current blocking layer formed on the second semiconductor layer; and forming a second electrode on the second semiconductor layer and the semiconductor region.

The method further includes the step of forming the current blocking layer comprising placing a first mask on a surface of the second semiconductor layer; and doping the surface of the second semiconductor layer using the first mask to form the semiconductor region of a conductivity type different than that of the second semiconductor layer; wherein the conductivity type of the semiconductor region is the first conductivity type; and wherein the semiconductor region is at least one of an undoped or a lightly doped semiconductor region.

The method further includes the step of forming the current blocking layer comprising forming a semiconductor region on top of the second semiconductor layer; wherein the step of forming the second electrode includes forming an ohmic contact between the second electrode and the second semiconductor layer other than where the current blocking layer contacts the second semiconductor layer; wherein the step of forming the current blocking layer further comprises adjusting a thickness of the current blocking layer to control a carrier distribution in the active layer that is spatially overlapped by the current blocking layer; wherein the step of forming the current blocking layer further comprises adjusting a doping concentration of the current blocking layer to control a carrier distribution in the active layer that is spatially overlapped by the current blocking layer; and wherein the step of forming the second electrode further comprises adjusting the ohmic contact of the second electrode to vary a voltage drop in an active region below the first electrode, wherein the voltage drop controls a carrier distribution in the active layer that is spatially overlapped by the current blocking layer.

In the descriptions of embodiments, it will be understood that when a layer (or film) is referred to as being 'on' another layer or substrate, it can be directly on another layer or substrate, or intervening layers may also be present. Further, it will be understood that when a layer is referred to as being 'under' another layer, it can be directly under another layer, and one or more intervening layers may also be present. In addition, it will also be understood that when a layer is referred to as being 'between' two layers, it can be the only layer between the two layers, or one or more intervening layers may also be present.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting device (LED) comprising:
a light emitting structure comprising a first semiconductor layer of a first conductivity type, an active layer adjacent the first semiconductor layer, and a second semiconductor layer of a second conductivity type adjacent the active layer;
a current blocking layer adjacent to the second semiconductor layer;
a first electrode adjacent the first semiconductor layer; and
a second electrode adjacent the second semiconductor layer; and
wherein the current blocking layer comprises a semiconductor region.

2. The LED of claim 1, wherein the current blocking layer comprises a GaN semiconductor layer.

3. The LED of claim 1, wherein the semiconductor region has a first conductivity type.

4. The LED of claim 1, wherein the semiconductor region is an undoped semiconductor region.

5. The LED of claim 1, wherein the semiconductor region is a lightly doped semiconductor region.

6. The LED of claim 1, wherein the first electrode spatially overlaps at least portion of the current blocking layer.

7. The LED of claim 1, wherein the current blocking layer is disposed in the second semiconductor layer.

8. The LED of claim 1, wherein the current blocking layer is disposed in the second electrode.

9. The LED of claim 1, wherein an ohmic contact is provided between the second semiconductor layer and the second electrode other than where the current blocking layer contacts the second semiconductor layer.

10. An LED package comprising:
the LED of claim 1; and
a package body in which the LED is disposed.

11. A lighting system comprising a light emitting module comprising the LED package of claim 10.

12. A method of manufacturing a light emitting device (LED), comprising
forming an active layer on a first semiconductor layer of a first conductivity type;
forming a second semiconductor layer of a second conductivity type on the active layer;
forming a current blocking layer including a semiconductor region on the second semiconductor layer;
forming a first electrode on the first semiconductor layer, wherein the first electrode is positioned to spatially overlap the current blocking layer formed on the second semiconductor layer; and
forming a second electrode on the second semiconductor layer and the semiconductor region.

13. The method of claim 12, wherein the step of forming the current blocking layer comprises:
placing a first mask on a surface of the second semiconductor layer; and
doping the surface of the second semiconductor layer using the first mask to form the semiconductor region of a conductivity type different than that of the second semiconductor layer.

14. The method of claim 12, wherein the step of forming the current blocking layer comprises forming a semiconductor region on top of the second semiconductor layer.

15. The method of claim 12, wherein the step of forming the current blocking layer further comprises adjusting a doping concentration of the current blocking layer to control a carrier distribution in the active layer that is spatially overlapped by the current blocking layer.
